(19) Europäisches Patentamt / European Patent Office / Office européen des brevets

(11) **EP 4 617 691 A1**

(12) **EUROPEAN PATENT APPLICATION**
published in accordance with Art. 153(4) EPC

(43) Date of publication:
**17.09.2025   Bulletin 2025/38**

(21) Application number: **23888956.2**

(22) Date of filing: **16.10.2023**

(51) International Patent Classification (IPC):
$G01R\ 31/392^{(2019.01)}$    $G01R\ 31/396^{(2019.01)}$
$G01R\ 31/3842^{(2019.01)}$    $G01R\ 19/00^{(2006.01)}$
$G01R\ 19/12^{(2006.01)}$    $G01R\ 19/165^{(2006.01)}$
$G01R\ 19/30^{(2006.01)}$    $G01R\ 19/10^{(2006.01)}$
$G08B\ 21/18^{(2006.01)}$    $G01R\ 31/56^{(2020.01)}$

(52) Cooperative Patent Classification (CPC):
G01R 19/00; G01R 19/10; G01R 19/12;
G01R 19/165; G01R 19/30; G01R 31/3842;
G01R 31/392; G01R 31/396; G01R 31/56;
G08B 21/18

(86) International application number:
**PCT/KR2023/015922**

(87) International publication number:
**WO 2024/101693 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:   **11.11.2022   KR 20220151069**

(71) Applicant: **LG Energy Solution, Ltd.**
**Seoul 07335 (KR)**

(72) Inventors:
• **KIM, Won Kyung**
**Daejeon 34122 (KR)**

• **LEE, Jeong Bin**
**Daejeon 34122 (KR)**
• **YOON, Sung Yul**
**Daejeon 34122 (KR)**
• **KIM, In Sik**
**Daejeon 34122 (KR)**
• **KIM, Soon Jong**
**Daejeon 34122 (KR)**
• **KWON, Ki Wook**
**Daejeon 34122 (KR)**
• **SONG, Young Seok**
**Daejeon 34122 (KR)**

(74) Representative: **Plasseraud IP**
**104 Rue de Richelieu**
**CS92104**
**75080 Paris Cedex 02 (FR)**

(54) **BATTERY DIAGNOSTIC DEVICE AND OPERATING METHOD THEREOF**

(57)   A battery diagnosis apparatus according to an embodiment disclosed herein includes an obtaining unit configured to obtain first voltage values of a plurality of respective battery units, an identifying unit configured to identify second voltage values in different idle periods from among the first voltage values, a determining unit configured to determine a voltage gradient indicating a change degree of the second voltage values of the plurality of respective battery units over time and determine a standard score (Z-score) of the voltage gradient for each of the plurality of battery units by using an average and a standard deviation of a plurality of voltage gradients one-to-one corresponding to the plurality of battery units, and a diagnosing unit configured to select, from among the plurality of battery units, a battery unit having the standard score out of a first reference range and the voltage gradient out of a second reference range and diagnose at least some of selected battery units as abnormal battery units.

EP 4 617 691 A1

ELECTRONIC DEVICE
103

BATTERY UNIT
111

BATTERY UNIT
113

⋮

BATTERY UNIT
115

104

BATTERY DIAGNOSIS
APPARATUS
101

COMMUNICATION
CIRCUIT
120

SENSOR
130

MEMORY
140

PROCESSOR
150

OBTAINING UNIT
141

IDENTIFYING
UNIT
143

DETERMINING
UNIT
145

DIAGNOSING
UNIT
147

ABNORMALITY
PROCESSING UNIT
149

106

USER TERMINAL
105

FIG.2

**Description**

**[TECHNICAL FIELD]**

CROSS-REFERENCE TO RELATED APPLICATION

This application claims priority to and the benefit of Korean Patent Application No. 10-2022-0151069 filed in the Korean Intellectual Property Office on November 11, 2022, the entire content of which is incorporated herein by reference.

TECHNICAL FIELD

Embodiments disclosed herein relate to a battery diagnosis apparatus and an operating method thereof.

**[BACKGROUND ART]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

**[DISCLOSURE]**

**[TECHNICAL PROBLEM]**

When a short circuit or a failure of another type occurs inside a battery, the possibility of damage to devices (e.g., EV, ESS) including the battery may increase.

Accordingly, there is a need for a scheme to reduce the possibility of damage to devices including a battery by detecting an abnormal state of the battery.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery diagnosis apparatus according to an embodiment disclosed herein includes an obtaining unit configured to obtain first voltage values of a plurality of respective battery units, an identifying unit configured to identify second voltage values in different idle periods from among the first voltage values, a determining unit configured to determine a voltage gradient indicating a change degree of the second voltage values of the plurality of respective battery units over time and determine a standard score (Z-score) of the voltage gradient for each of the plurality of battery units by using an average and a standard deviation of a plurality of voltage gradients one-to-one corresponding to the plurality of battery units, and a diagnosing unit configured to select, from among the plurality of battery units, a battery unit having the standard score out of a first reference range and the voltage gradient out of a second reference range and diagnose at least some of selected battery units as abnormal battery units.

In the battery diagnosis apparatus according to an embodiment disclosed herein, the determining unit may be further configured to determine average voltage values of the different idle periods of each of the plurality of battery units, based on the second voltage values and determine the voltage gradient based on the average voltage values.

In the battery diagnosis apparatus according to an embodiment disclosed herein, the diagnosing unit may be further configured to select, from among the plurality of battery units, a battery unit having the standard score greater than a first upper limit of the first reference range and the voltage gradient greater than a second upper limit of the second reference range and diagnose at least some of selected battery units as abnormal battery units, when the different idle periods are idle periods after different charging.

In the battery diagnosis apparatus according to an embodiment disclosed herein, the diagnosing unit may be further configured to select, from among the plurality of battery units, a battery unit having the standard score less than a first lower limit of the first reference range and the voltage gradient less than a second lower limit of the second reference range and diagnose at least some of selected battery units as abnormal battery units, when the different idle periods are idle periods after different discharging.

In the battery diagnosis apparatus according to an embodiment disclosed herein, the diagnosing unit may be further configured to diagnose as an abnormal battery unit, among the selected battery units, a battery unit in which a difference between a maximum value and a minimum value of the second voltage values is greater than a designated difference value.

In the battery diagnosis apparatus according to an embodiment disclosed herein, the identifying unit may be further configured to set the different idle periods as periods having voltage values, current values, the amounts of charge, and/or the amounts of discharge in designated ranges.

The battery diagnosis apparatus according to an embodiment disclosed herein may further include an abnormality processing unit configured to perform an abnormality processing function based on an abnormality diagnosis result of each of the plurality of battery units, in which the abnormality processing function includes a notification function or a shortcircuit function.

A battery diagnosis method according to an embodiment disclosed herein includes obtaining first voltage values of a plurality of respective battery units, identifying second voltage values in different idle periods from among the first voltage values, determining a voltage gradient indicating a change degree of the second voltage values of the plurality of respective battery units over time, determining a standard score (Z-score) of the voltage gradient for each of the plurality of battery units by using an average and a standard deviation of a plurality of voltage gradients one-to-one corresponding to the plurality of battery units, selecting from among the plurality of battery units, a battery unit having the standard score out of a first reference range and the voltage gradient out of a second reference range, and diagnosing at least some of selected battery units as abnormal battery units.

In the battery diagnosis method according to an embodiment disclosed herein, the determining of the voltage gradient may include determining average voltage values of the different idle periods of each of the plurality of battery units, based on the second voltage values and determining the voltage gradient based on the average voltage values.

In the battery diagnosis method according to an embodiment disclosed herein, the selecting of the battery unit may include selecting, from among the plurality of battery units, a battery unit having the standard score greater than a first upper limit of the first reference range and the voltage gradient greater than a second upper limit of the second reference range, when the different idle periods are idle periods after different charging.

In the battery diagnosis method according to an embodiment disclosed herein, the selecting of the battery unit may include selecting, from among the plurality of battery units, a battery unit having the standard score less than a first lower limit of the first reference range and the voltage gradient less than a second lower limit of the second reference range, when the different idle periods are idle periods after different discharging.

In the battery diagnosis method according to an embodiment disclosed herein, the diagnosing of the at least some of the selected battery units as the abnormal battery units may include diagnosing as an abnormal battery unit, among the selected battery units, a battery unit in which a difference between a maximum value and a minimum value of the second voltage values is greater than a designated difference value.

The battery diagnosis method according to an embodiment disclosed herein may further include setting the different idle periods as periods having voltage values, current values, the amounts of charge, and/or the amounts of discharge in designated ranges.

The battery diagnosis method according to an embodiment disclosed herein may further include performing an abnormality processing function based on an abnormality diagnosis result of each of the plurality of battery units, in which the abnormality processing function includes a notification function or a shortcircuit function.

**[ADVANTAGEOUS EFFECTS]**

A battery diagnosis apparatus and an operating method thereof according to various embodiments disclosed herein may detect occurrence of a short circuit or a failure of another type inside a battery.

A battery diagnosis apparatus and an operating method thereof according to various embodiments disclosed herein may process the detected short circuit or failure of another type inside the battery.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

Moreover, various effects recognized directly or indirectly from the disclosure may be provided.

**[DESCRIPTION OF DRAWINGS]**

FIG. 1 shows graphs of a difference between a voltage change degree of a normal battery unit and a voltage change degree of an abnormal battery unit in idle periods.

FIG. 2 is a block diagram of a battery diagnosis apparatus according to an embodiment.

FIG. 3A is a graph showing an example where an idle period is set after charging of a battery unit, according to an embodiment.

FIG. 3B is a graph showing an example where an idle period is set after discharging of a battery unit, according to an embodiment.

FIG. 4 is a graph showing an example where abnormality is diagnosed based on a standard score of a battery unit, according to an embodiment.

FIG. 5 is an operating flowchart of a battery diagnosis apparatus according to an embodiment.

FIG. 6 is an operating flowchart of a battery diagnosis apparatus according to an embodiment.

**[MODE FOR INVENTION]**

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

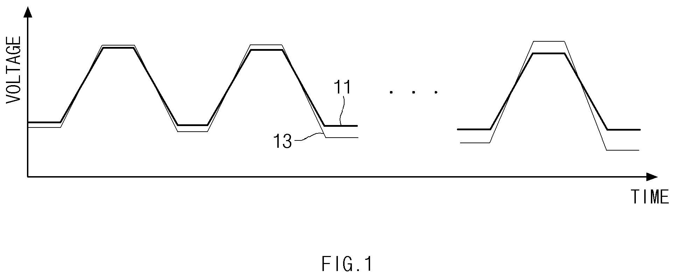

FIG. 1 shows graphs of a difference between a voltage change degree of a normal battery unit and a voltage change degree of an abnormal battery unit in idle periods.

Referring to FIG. 1, a graph 10 showing a voltage 11 of a normal battery unit and a voltage 13 of an abnormal battery unit may be seen. It may be seen from the graph 10 that for the voltage 11 of the normal battery unit, a voltage value difference is relatively small in each of idle periods in which a voltage value is maintained constant (e.g., idle periods after charging or discharging). On the other hand, it may be seen from the graph 10 that for the voltage 13 of the abnormal battery unit, a voltage value difference is relatively large in each of the idle periods. For example, for the voltage 13 of the abnormal battery unit, the voltage value may rise significantly as the idle periods continue after charging. For example, for the voltage 13 of the abnormal battery unit, the voltage value may drop significantly as the idle periods continue after discharging. When a short circuit or a failure of another type occurs inside a battery unit, an abnormal behavior like the voltage 13 of the abnormal battery unit may appear.

As such, damage to an electronic device may occur due to the battery unit showing the abnormal behavior like the voltage 13 of the abnormal battery unit. Thus, a battery unit having an abnormal behavior may be detected from among battery units, and may need to be appropriately processed.

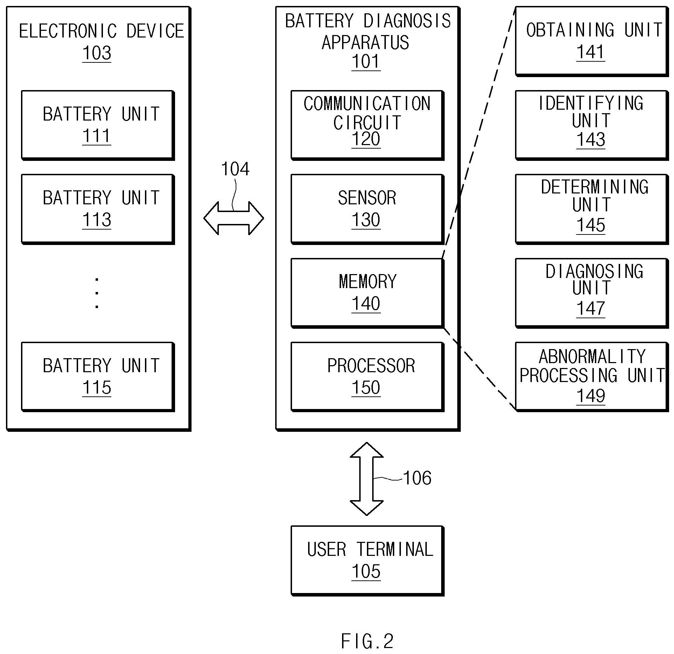

FIG. 2 is a block diagram of a battery diagnosis apparatus according to an embodiment.

Referring to FIG. 2, the battery diagnosis apparatus 101 may be wiredly and/or wirelessly connected to an electronic device 103 and a user terminal 105.

In an embodiment, connection 104 between the battery diagnosis apparatus 101 and the electronic device 103 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4$^{th}$-Generation (4G) network, a 5$^{th}$-Generation (5G) network).

In another embodiment, the connection 104 between the battery diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

In an embodiment, connection 106 between the battery diagnosis apparatus 101 and the user terminal 105 may be communication connection through a wired and/or wireless network.

In an embodiment, the electronic device 103 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 103 may include one or more battery units 111, 113, and 115. Each of the one or more battery units 111, 113, and 115 may be a battery cell, a battery module, a battery pack, or a battery rack.

In an embodiment, the user terminal 105 may be a mobile device (e.g., a mobile phone, a laptop computer, a smart phone, a smart pad), or a personal computer (PC).

In an embodiment, the battery diagnosis apparatus 101 may include a communication circuit 120, a sensor 130, a memory 140, and a processor 150. According to an embodiment, the battery diagnosis apparatus 101 shown in FIG. 2 may further include at least one component (e.g., a display, an input device, or an output device) in addition to components shown in FIG. 2.

In an embodiment, the communication circuit 120 may establish a wired communication channel and/or a wireless communication channel between the battery diagnosis apparatus 101 and the electronic device 103 and/or the user terminal 105, and transmit and receive data to and from the electronic device 103 and/or the user terminal 105 through the established communication channel.

In an embodiment, the sensor 130 may obtain values related to states of the battery units 111, 113, and 115 of the electronic device 103. In an embodiment, the values related to the states may indicate one or more values of voltages, currents, resistances, states of charge (SoC), states of health (SoH), or temperatures of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery diagnosis apparatus 101. For example, the data may include software (or an instruction related thereto), input data, or output data. In an embodiment, the instruction, when executed by the processor 150, may cause the battery abnormality diagnosis apparatus 101 to perform operations defined by the instruction.

In an embodiment, the memory 140 may include one or more software (e.g., an obtaining unit 141, an identifying unit 143, a determining unit 145, a diagnosing unit 147, and an abnormality processing unit 149).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., the obtaining unit 141, the identifying unit 143, the determining unit 145, the diagnosing unit 147, and the abnormality processing unit 149) to control at least one other component (e.g., a hardware or software component) of the battery diagnosis apparatus 101 connected to the processor 150 and perform various data processing or operations.

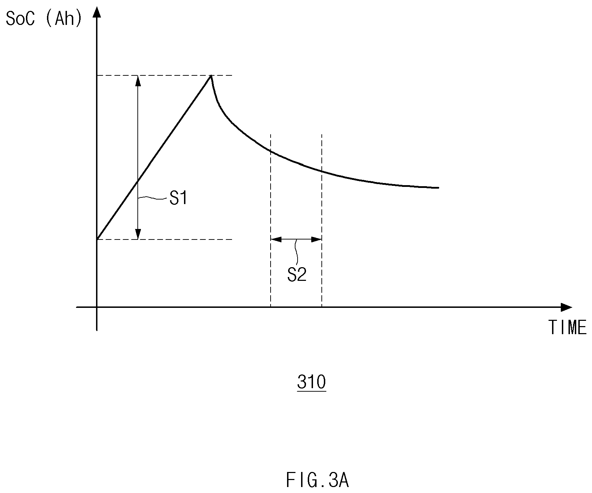

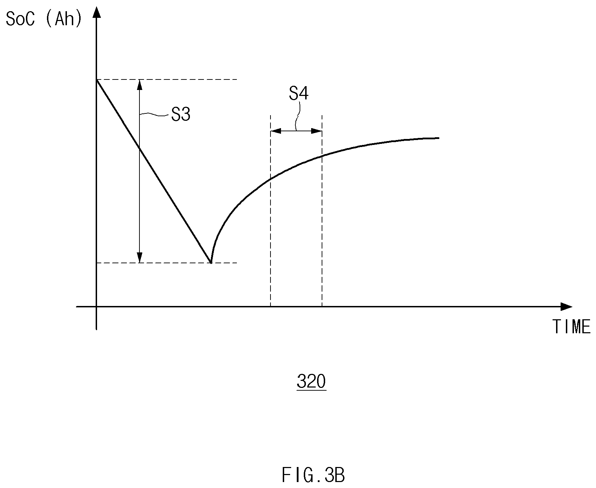

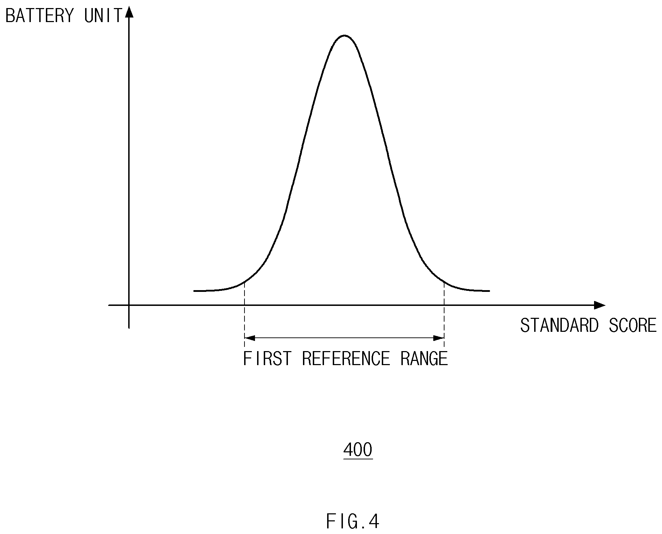

Hereinbelow, referring to FIGS. 3A, 3B, and 4, a description will be made of a method, performed by the battery diagnosis apparatus 101, of diagnosing abnormality of the battery units 111, 113, and 115 through the obtaining unit 141, the identifying unit 143, the determining unit 145, the diagnosing unit 147, and/or the abnormality processing unit 149.

FIG. 3A is a graph showing an example where an idle period is set after charging of a battery unit, according to an embodiment. FIG. 3B is a graph showing an example where an idle period is set after discharging of a battery unit, according to an embodiment. FIG. 4 is a graph showing an example where abnormality is diagnosed based on a standard score of a battery unit, according to an embodiment. FIGS. 3A, 3B, and 4 will be described using the components of FIG. 2.

In an embodiment, the obtaining unit 141 may obtain first voltage values of the plurality of respective battery units 111, 113, and 115. In an embodiment, the obtaining unit 141 may obtain a plurality of voltage profiles respectively indicating voltage changes of the plurality of battery units 111, 113, and 115 over time. The obtaining unit 141 may obtain the first voltage values based on the obtained plurality of voltage profiles.

In an embodiment, the obtaining unit 141 may obtain the first voltage values of the plurality of respective battery unit 111, 113, and 115 through the electronic device 103 connected through a wired and/or wireless network.

In an embodiment, the identifying unit 143 may identify second voltage values in different idle periods from among the first voltage values. In an embodiment, the identifying unit 143 may set the different idle periods as periods having voltage values, current values, the amounts of charge, and/or the amounts of discharge in designated ranges. The identifying unit 143 may extract the different idle periods for each of the plurality of battery units 111, 113, and 115 from the obtained plurality of voltage profiles, and identify the second voltage values in the corresponding periods for the plurality of respective battery units 111, 113, and 115.

In an embodiment, the different idle periods may be idle periods after different charging or idle periods after different discharging.

For example, referring to FIG. 3A, a charging period S1 and an idle period S2 after charging may be seen from the graph 310. In an embodiment, the identifying unit 143 may identify the charging period S1 having a designated amount of charging from the plurality of SOC profiles of the plurality of respective battery units 111, 113, and 115. To this end, the obtaining unit 141 may obtain the plurality of SOC profiles of the plurality of respective battery unit 111, 113, and 115 through the electronic device 103 connected through a wired and/or wireless network. In an embodiment, the identifying unit 143 may extract the idle period S2 after charging, based on a voltage value and/or a current value of each of the plurality of battery units 111, 113, and 115 after the charging period S1. For example, the identifying unit 143 may extract, as the idle period S2 after charging, a period in which the current value of the battery unit 111, 113, or 115 is in a first current range (e.g., a range of 0 A to 1 A).

In another example, referring to FIG. 3B, a discharging period S3 and an idle period S4 after discharging may be seen from a graph 320. In an embodiment, the identifying unit 143 may identify the discharging period S3 having a designated amount of discharging from the plurality of SOC profiles of the plurality of respective battery units 111, 113, and 115. In an embodiment, the identifying unit 143 may extract the idle period S4 after discharging, based on a voltage value and/or a current value of each of the plurality of battery units 111, 113, and 115 after the discharging period S3. For example, the identifying unit 143 may extract, as the idle period S2 after charging, a period in which the current value of the battery unit 111, 113, or 115 is in a second current range (e.g., a range of -1 A to 0 A).

In an embodiment, the identifying unit 143 may identify the second voltage values of the plurality of respective battery units 111, 113, and 115 in the extracted different idle periods (e.g., different idle periods after charging or different idle periods after discharging).

In an embodiment, the determining unit 145 may determine a voltage gradient of the second voltage values of the plurality of respective battery units 111, 113, and 115 over time. In an embodiment, the determining unit 145 may determine average voltage values of different idle periods (e.g., idle periods after different charging or idle periods after different discharging) of each of the plurality of battery units 111, 113, and 115, based on the second voltage values. The determining unit 145 may determine the voltage gradient based on the average voltage values. For example, the determining unit 145 may determine the average voltage values of the idle periods after different charging for the plurality of respective battery units 111, 113, and 115, as shown in Table 1 below.

[Table 1]

| Idle Period | Battery Unit | | | |
|---|---|---|---|---|
| | 111 | 113 | ... | 115 |
| Idle Period after First Charging | 4.0514 | 4.0502 | ... | 4.0531 |

(continued)

| Idle Period | Battery Unit | | | |
|---|---|---|---|---|
| Idle Period after Second Charging | 4.0513 | 4.0528 | ... | 4.0531 |
| Idle Period after Third Charging | 4.0513 | 4.0566 | ... | 4.0530 |

Referring to [Table 1], an average voltage of the battery unit 111 is maintained constant such as 4.0514, 4.0513, and 4.0513 even when idle periods after charging continue, whereas an average voltage of the battery unit 113 relatively rises such as 4.0502, 4.5028, and 4.0566 even when the idle periods after charging continue.

In another example, the determining unit 145 may determine the average voltage values of the idle periods after different discharging for each of the plurality of battery units 111, 113, and 115, as shown in Table 2 below.

[Table 2]

| Idle Period | Battery Unit | | | |
|---|---|---|---|---|
| | 111 | 113 | ... | 115 |
| Idle Period after First Discharging | 3.5122 | 3.5125 | ... | 3.5122 |
| Idle Period after Second Discharging | 3.5122 | 3.5157 | ... | 3.5122 |
| Idle Period after Third Discharging | 3.5122 | 3.5191 | ... | 3.5122 |

Referring to [Table 2], an average voltage of the battery unit 111 is maintained constant such as 3.5122, 3.5122, and 3.5122 even when idle periods after discharging continue, whereas an average voltage of the battery unit 113 relatively rises such as 3.5125, 3.5157, and 3.5191 even when the idle periods after discharging continue.

In an embodiment, the determining unit 145 may determine the voltage gradient based on a linear regression scheme. For example, the determining unit 145 may determine a plurality of voltage gradients for the plurality of respective battery units 111, 113, and 115 based on the linear regression scheme by using all of the second voltage values of the plurality of respective battery units 111, 113, and 115 as input factors. In another example, the determining unit 145 may determine the plurality of voltage gradients based on the linear regression scheme by using, as input factors, average voltage values in different idle periods of each of the plurality of battery units 111, 113, and 115.

In an embodiment, the determining unit 145 may determine a standard score of a voltage gradient for each of the plurality of battery units 111, 113, and 115 by using an average and a standard deviation of the plurality of voltage gradients one-to-one corresponding to the plurality of battery units 111, 113, and 115. For example, the determining unit 145 may determine the standard score according to Equation 1.

[Equation 1]

$$z = \frac{x - \mu}{\sigma}$$

In Equation 1, z indicates a standard score of a voltage gradient of the battery unit 111, 113, or 115, x indicates a voltage gradient of the battery unit 111, 113, or 115, $\mu$ indicates an average of a plurality of voltage gradients one-to-one corresponding to the plurality of battery units 111, 113, and 115, and $\sigma$ indicates a standard deviation.

In an embodiment, the diagnosing unit 147 may select, from among the plurality of battery units 111, 113, and 115, a battery unit that has the standard score out of a first reference range and has the voltage gradient out of a second reference range. For example, referring to FIG. 4, the diagnosing unit 147 may diagnose all battery units having a standard score out of the first reference range of a graph 400 as abnormal battery units.

For example, when the different idle periods are idle periods after different charging, the diagnosing unit 147 may select, from among the plurality of battery units 111, 113, and 115, a battery unit that has a standard score greater than a first upper limit of the first reference range and has a voltage gradient greater than a second upper limit of the second reference range.

In another example, when the different idle periods are idle periods after different charging, the diagnosing unit 147 may select, from among the plurality of battery units 111, 113, and 115, a battery unit that has a standard score less than a first lower limit of the first reference range and has a voltage gradient less than a second lower limit of the second reference range.

In an embodiment, the diagnosing unit 147 may diagnose at least some of the selected battery units as abnormal battery units. In an embodiment, the diagnosing unit 147 may diagnose as an abnormal battery unit, among the selected battery units, a battery unit in which a difference between a maximum value and a minimum value of the second voltage values is greater than a designated difference value.

In an embodiment, the diagnosing unit 147 may diagnose abnormality of a battery unit based on a voltage gradient, a standard score of the voltage gradient, and a difference between a maximum value and a minimum value, for each of the plurality of battery units 111, 113, and 115, as shown in Table 3.

[Table 3]

|  | Battery Unit | | | |
|---|---|---|---|---|
|  | 111 | 113 | ... | 115 |
| Voltage Gradient | 0.000231 | -0.003 | ... | 0.0002 |
| Standard Score of Voltage Gradient | 0.27735 | -3.6055 | ... | 0.27735 |
| Difference between Maximum Value and Minimum Value | 0.013 | 0.045 | ... | 0.013 |

For example, when the different idle periods are idle periods after discharging, the first reference range is from -3 to 3, the second reference range is from -0.01 to 0.01, and a designated difference is 0.04, then the battery unit 113 of Table 3 has a standard score of -3.6055 out of the first reference range, a voltage gradient of -0.003 out of the second reference range, and a difference of 0.045 between a maximum value and a minimum value, greater than a designated difference value, such that the diagnosing unit 147 may diagnose the battery unit 113 as an abnormal battery unit.

In an embodiment, the abnormality processing unit 149 may perform an abnormality processing function based on abnormality diagnosis results for the plurality of battery units 111, 113, and 115. In an embodiment, the abnormality processing function may include a notification function or a shortcircuit function.

For example, the abnormality processing unit 149 may transmit the abnormality diagnosis results of the plurality of battery units 111, 113, and 115 to the user terminal 105 connected through a wired and/or wireless network.

In another embodiment, the abnormality processing unit 149 may isolate the abnormality battery unit from the electronic device 103 based on the abnormality diagnosis results of the plurality of battery units 111, 113, and 115. Herein, isolation may include electrical and/or mechanical isolation.

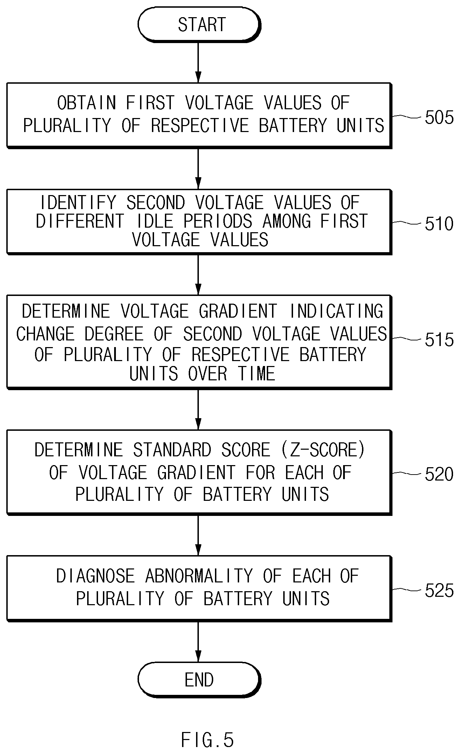

FIG. 5 is an operating flowchart of a battery diagnosis apparatus according to an embodiment. FIG. 5 will be described using components of FIG. 2.

The embodiment shown in FIG. 5 may be an example, and an order of operations according to various embodiments of the present disclosure may be different from that shown in FIG. 5, and some operations shown in FIG. 5 may be omitted, the order of the operations may be changed, or the operations may be merged.

Referring to FIG. 5, in operation 505, the battery diagnosis apparatus 101 may obtain the first voltage values of the plurality of respective battery units 111, 113, and 115. In an embodiment, the battery diagnosis apparatus 101 may obtain a plurality of voltage profiles respectively indicating voltage changes of the plurality of battery units 111, 113, and 115 over time. The battery diagnosis apparatus 101 may obtain the first voltage values based on the obtained plurality of voltage profiles.

In an embodiment, the battery diagnosis apparatus 101 may obtain the first voltage values of the plurality of respective battery unit 111, 113, and 115 through the electronic device 103 connected through a wired and/or wireless network.

In operation 510, the battery diagnosis apparatus 101 may identify the second voltage values in different idle periods from among the first voltage values obtained in operation 505. In an embodiment, the battery diagnosis apparatus 101 may set the different idle periods as periods having voltage values, current values, the amounts of charge, and/or the amounts of discharge in designated ranges. The battery diagnosis apparatus 101 may extract the different idle periods for each of the plurality of battery units 111, 113, and 115 from the obtained plurality of voltage profiles, and identify the second voltage values in the corresponding periods for the plurality of respective battery units 111, 113, and 115.

In an embodiment, the different idle periods may be idle periods after different charging or idle periods after different discharging.

In operation 515, the battery diagnosis apparatus 101 may determine a voltage gradient of the second voltage values of the plurality of respective battery units 111, 113, and 115 over time. In an embodiment, the battery diagnosis apparatus 101 may determine average voltage values of different idle periods (e.g., idle periods after different charging or idle periods after different discharging) of each of the plurality of battery units 111, 113, and 115, based on the second voltage values. The battery diagnosis apparatus 101 may determine the voltage gradient based on the average voltage values.

In an embodiment, the battery diagnosis apparatus 101 may determine the voltage gradient based on the linear regression scheme. For example, the battery diagnosis apparatus 101 may determine the plurality of voltage gradients for the plurality of respective battery units 111, 113, and 115 based on the linear regression scheme by using all of the second voltage values of the plurality of respective battery units 111, 113, and 115 as input factors. In another example, the battery diagnosis apparatus 101 may determine the plurality of voltage gradients based on the linear regression scheme by using, as input factors, average voltage values in different idle periods of each of the plurality of battery units 111, 113, and 115.

In operation 520, the battery diagnosis apparatus 101 may determine a standard score of a voltage gradient for each of the plurality of battery units 111, 113, and 115 by using an average and a standard deviation of the plurality of voltage gradients one-to-one corresponding to the plurality of battery units 111, 113, and 115.

In operation 525, the battery diagnosis apparatus 101 may diagnose an abnormality of each of the plurality of battery units 111, 113, and 115. In an embodiment, the battery diagnosis apparatus 101 may diagnose the abnormality of each of the plurality of battery units 111, 113, and 115, based on the voltage gradient determined in operation 515 and the standard score determined in operation 520.

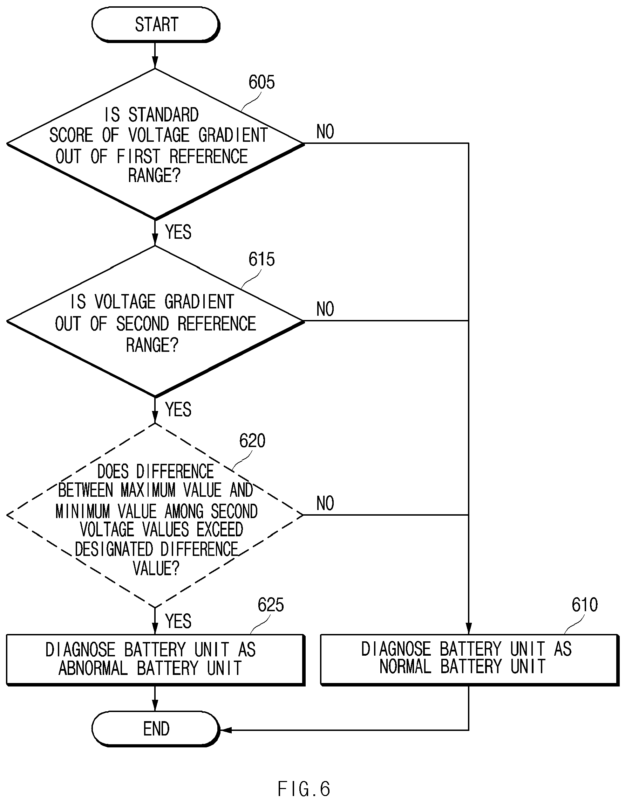

A more detailed description will be made of operation 525 of diagnosing the abnormality of each of the plurality of battery units 111, 113, and 115 by the battery diagnosis apparatus with reference to FIG. 6

FIG. 6 is an operating flowchart of a battery diagnosis apparatus according to an embodiment. FIG. 6 will be described using components of FIG. 2.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged. For example, operation 620 may be omitted from FIG. 6.

In operation 605, the battery diagnosis apparatus 101 may identify whether the standard score of the voltage gradient of the battery unit 111, 113, or 115 is out of the first reference range. For example, when different idle periods are idle periods after different charging, the battery diagnosis apparatus 101 may identify whether the standard score of the voltage gradient of the battery unit 111, 113, or 115 is greater than the first upper limit of the first reference range. In another example, when the different idle periods are idle periods after different discharging, the battery diagnosis apparatus 101 may identify whether the standard score of the voltage gradient of the battery unit 111, 113, or 115 is less than the first lower limit of the first reference range.

When the standard score of the voltage gradient of the battery unit 111, 113, or 115 is identified as being within the first reference range in operation 605 ('NO'), the battery diagnosis apparatus 101 may diagnose the battery unit 111, 113, or 115 as a normal battery unit in operation 610.

When the standard score of the voltage gradient of the battery unit 111, 113, or 115 is identified as being out of the first reference range in operation 605 ('YES'), the battery diagnosis apparatus 101 may identify whether the voltage gradient of the battery unit 111, 113, or 115 is less than a second reference value in operation 615. For example, when different idle periods are idle periods after different charging, the battery diagnosis apparatus 101 may identify whether the voltage gradient of the battery unit 111, 113, or 115 is greater than the second upper limit of the second reference range. In another example, when the different idle periods are idle periods after different discharging, the battery diagnosis apparatus 101 may identify whether the voltage gradient of the battery unit 111, 113, or 115 is less than the second lower limit of the second reference range.

When the voltage gradient of the battery unit 111, 113, or 115 is identified as being within the second reference range in operation 615 ('NO'), the battery diagnosis apparatus 101 may diagnose the battery unit 111, 113, or 115 as a normal battery unit in operation 610.

When the voltage gradient of the battery unit 111, 113, or 115 is identified as being out of the second reference range in operation 615 ('YES'), the battery diagnosis apparatus 101 may identify whether the difference between the maximum value and the minimum value among the second voltage values of the battery unit 111, 113, or 115 exceeds the designated difference value in operation 620.

When the difference between the maximum value and the minimum value among the second voltage values of the battery unit 111, 113, or 115 is identified as being less than the designated difference value in operation 620 ('NO'), the battery diagnosis apparatus 101 may diagnose the battery unit 111, 113, or 115 as a normal battery unit in operation 610.

When the difference between the maximum value and the minimum value among the second voltage values of the battery unit 111, 113, or 115 is identified as exceeding the designated difference value in operation 620 ('YES'), the battery diagnosis apparatus 101 may diagnose the battery unit 111, 113, or 115 as an abnormal battery unit in operation 625.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

**Claims**

1. A battery diagnosis apparatus comprising:

    an obtaining unit configured to obtain first voltage values of a plurality of respective battery units;
    an identifying unit configured to identify second voltage values in different idle periods from among the first voltage values;
    a determining unit configured to determine a voltage gradient indicating a change degree of the second voltage values of the plurality of respective battery units over time and determine a standard score (Z-score) of the voltage gradient for each of the plurality of battery units by using an average and a standard deviation of a plurality of voltage gradients one-to-one corresponding to the plurality of battery units; and
    a diagnosing unit configured to select, from among the plurality of battery units, a battery unit having the standard score out of a first reference range and the voltage gradient out of a second reference range and diagnose at least some of selected battery units as abnormal battery units.

2. The battery diagnosis apparatus of claim 1, wherein the determining unit is further configured to:

    determine average voltage values of the different idle periods of each of the plurality of battery units, based on the second voltage values; and
    determine the voltage gradient based on the average voltage values.

3. The battery diagnosis apparatus of claim 1, wherein the diagnosing unit is further configured to select, from among the plurality of battery units, a battery unit having the standard score greater than a first upper limit of the first reference range and the voltage gradient greater than a second upper limit of the second reference range and diagnose at least some of selected battery units as abnormal battery units, when the different idle periods are idle periods after different charging.

4. The battery diagnosis apparatus of claim 1, wherein the diagnosing unit is further configured to select, from among the plurality of battery units, a battery unit having the standard score less than a first lower limit of the first reference range and the voltage gradient less than a second lower limit of the second reference range and diagnose at least some of selected battery units as abnormal battery units, when the different idle periods are idle periods after different discharging.

5. The battery diagnosis apparatus of claim 1, wherein the diagnosing unit is further configured to diagnose as an abnormal battery unit, among the selected battery units, a battery unit in which a difference between a maximum value and a minimum value of the second voltage values is greater than a designated difference value.

6. The battery diagnosis apparatus of claim 1, wherein the identifying unit is further configured to set the different idle periods as periods having voltage values, current values, the amounts of charge, and/or the amounts of discharge in designated ranges.

7. The battery diagnosis apparatus of claim 1, further comprising an abnormality processing unit configured to perform an abnormality processing function based on an abnormality diagnosis result of each of the plurality of battery units, wherein the abnormality processing function comprises a notification function or a shortcircuit function.

8. A battery diagnosis method comprising:

    obtaining first voltage values of a plurality of respective battery units;
    identifying second voltage values in different idle periods from among the first voltage values;
    determining a voltage gradient indicating a change degree of the second voltage values of the plurality of respective battery units over time;
    determining a standard score (Z-score) of the voltage gradient for each of the plurality of battery units by using an average and a standard deviation of a plurality of voltage gradients one-to-one corresponding to the plurality of battery units;
selecting from among the plurality of battery units, a battery unit having the standard score out of a first reference range and the voltage gradient out of a second reference range; and
diagnosing at least some of selected battery units as abnormal battery units.

9. The battery diagnosis method of claim 8, wherein the determining of the voltage gradient comprises:

determining average voltage values of the different idle periods of each of the plurality of battery units, based on the second voltage values; and
determining the voltage gradient based on the average voltage values.

10. The battery diagnosis method of claim 8, wherein the selecting of the battery unit comprises selecting, from among the plurality of battery units, a battery unit having the standard score greater than a first upper limit of the first reference range and the voltage gradient greater than a second upper limit of the second reference range, when the different idle periods are idle periods after different charging.

11. The battery diagnosis method of claim 8, wherein the selecting of the battery unit comprises selecting, from among the plurality of battery units, a battery unit having the standard score less than a first lower limit of the first reference range and the voltage gradient less than a second lower limit of the second reference range, when the different idle periods are idle periods after different discharging.

12. The battery diagnosis method of claim 8, wherein the diagnosing of the at least some of the selected battery units as the abnormal battery units comprises diagnosing as an abnormal battery unit, among the selected battery units, a battery unit in which a difference between a maximum value and a minimum value of the second voltage values is greater than a designated difference value.

13. The battery diagnosis method of claim 8, further comprising setting the different idle periods as periods having voltage values, current values, the amounts of charge, and/or the amounts of discharge in designated ranges.

14. The battery diagnosis method of claim 8, further comprising performing an abnormality processing function based on an abnormality diagnosis result of each of the plurality of battery units,
wherein the abnormality processing function comprises a notification function or a shortcircuit function.

FIG.1

ELECTRONIC DEVICE
103

BATTERY UNIT
111

BATTERY UNIT
113

⋮

BATTERY UNIT
115

104

BATTERY DIAGNOSIS
APPARATUS
101

COMMUNICATION
CIRCUIT
120

SENSOR
130

MEMORY
140

PROCESSOR
150

OBTAINING UNIT
141

IDENTIFYING
UNIT
143

DETERMINING
UNIT
145

DIAGNOSING
UNIT
147

ABNORMALITY
PROCESSING UNIT
149

106

USER TERMINAL
105

FIG.2

310

FIG.3A

320

FIG.3B

BATTERY UNIT

STANDARD SCORE

FIRST REFERENCE RANGE

400

FIG.4

```
        ┌─────────────┐
        │    START    │
        └─────────────┘
               │
               ▼
┌──────────────────────────────────┐
│   OBTAIN FIRST VOLTAGE VALUES OF  │── 505
│ PLURALITY OF RESPECTIVE BATTERY UNITS│
└──────────────────────────────────┘
               │
               ▼
┌──────────────────────────────────┐
│  IDENTIFY SECOND VOLTAGE VALUES OF│
│  DIFFERENT IDLE PERIODS AMONG FIRST│── 510
│           VOLTAGE VALUES          │
└──────────────────────────────────┘
               │
               ▼
┌──────────────────────────────────┐
│ DETERMINE VOLTAGE GRADIENT INDICATING│
│ CHANGE DEGREE OF SECOND VOLTAGE VALUES│── 515
│  OF PLURALITY OF RESPECTIVE BATTERY│
│          UNITS OVER TIME          │
└──────────────────────────────────┘
               │
               ▼
┌──────────────────────────────────┐
│  DETERMINE STANDARD SCORE (Z-SCORE)│
│   OF VOLTAGE GRADIENT FOR EACH OF │── 520
│      PLURALITY OF BATTERY UNITS   │
└──────────────────────────────────┘
               │
               ▼
┌──────────────────────────────────┐
│   DIAGNOSE ABNORMALITY OF EACH OF │── 525
│      PLURALITY OF BATTERY UNITS   │
└──────────────────────────────────┘
               │
               ▼
        ┌─────────────┐
        │     END     │
        └─────────────┘
```

FIG.5

START

605

IS STANDARD
SCORE OF VOLTAGE GRADIENT
OUT OF FIRST REFERENCE
RANGE? — NO

YES

615

IS VOLTAGE GRADIENT
OUT OF SECOND REFERENCE
RANGE? — NO

YES

620

DOES DIFFERENCE
BETWEEN MAXIMUM VALUE AND
MINIMUM VALUE AMONG SECOND
VOLTAGE VALUES EXCEED
DESIGNATED DIFFERENCE
VALUE? — NO

YES

625

DIAGNOSE BATTERY UNIT AS
ABNORMAL BATTERY UNIT

610

DIAGNOSE BATTERY UNIT AS
NORMAL BATTERY UNIT

END

FIG.6

## INTERNATIONAL SEARCH REPORT

| International application No. |
|---|
| **PCT/KR2023/015922** |

**A. CLASSIFICATION OF SUBJECT MATTER**

**G01R 31/392**(2019.01)i; **G01R 31/396**(2019.01)i; **G01R 31/3842**(2019.01)i; **G01R 19/00**(2006.01)i; **G01R 19/12**(2006.01)i; **G01R 19/165**(2006.01)i; **G01R 19/30**(2006.01)i; **G01R 19/10**(2006.01)i; **G08B 21/18**(2006.01)i; **G01R 31/56**(2020.01)i

According to International Patent Classification (IPC) or to both national classification and IPC

**B. FIELDS SEARCHED**

Minimum documentation searched (classification system followed by classification symbols)

G01R 31/392(2019.01); B60L 50/50(2019.01); B60L 58/10(2019.01); B60L 58/22(2019.01); G01R 31/36(2006.01); G01R 31/367(2019.01); G01R 31/382(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 복수(plural), 배터리(battery), 전압(voltage), 기울기(slope), 평균(average), 표준편차(standard deviation), 이상(abnormal), 기준 범위(reference range)

**C. DOCUMENTS CONSIDERED TO BE RELEVANT**

| Category* | Citation of document, with indication, where appropriate, of the relevant passages | Relevant to claim No. |
|---|---|---|
| A | KR 10-2022-0048782 A (LG ENERGY SOLUTION, LTD.) 20 April 2022 (2022-04-20)<br>See paragraph [0044] and figure 2. | 1-14 |
| A | KR 10-2022-0019637 A (LG ENERGY SOLUTION, LTD.) 17 February 2022 (2022-02-17)<br>See paragraphs [0044]-[0048] and claim 4. | 1-14 |
| A | KR 10-2441800 B1 (OCI COMPANY LTD.) 13 September 2022 (2022-09-13)<br>See claims 1-3. | 1-14 |
| A | CN 113442787 A (SHANGHAI KLCLEAR NEW ENERGY TECHNOLOGY CO., LTD.) 28 September 2021 (2021-09-28)<br>See claims 1-5. | 1-14 |
| A | KR 10-2022-0126920 A (KYUNGPOOK NATIONAL UNIVERSITY INDUSTRY-ACADEMIC COOPERATION FOUNDATION) 19 September 2022 (2022-09-19)<br>See claim 7. | 1-14 |

☐ Further documents are listed in the continuation of Box C.          ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **18 January 2024** | **18 January 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/015922**

| Patent document cited in search report | | | Publication date (day/month/year) | Patent family member(s) | | | Publication date (day/month/year) |
|---|---|---|---|---|---|---|---|
| KR | 10-2022-0048782 | A | 20 April 2022 | CN | 115885188 | A | 31 March 2023 |
| | | | | EP | 4202463 | A1 | 28 June 2023 |
| | | | | US | 2023-0243894 | A1 | 03 August 2023 |
| | | | | WO | 2022-080871 | A1 | 21 April 2022 |
| KR | 10-2022-0019637 | A | 17 February 2022 | CN | 115867815 | A | 28 March 2023 |
| | | | | EP | 4155744 | A1 | 29 March 2023 |
| | | | | JP | 2023-529734 | A | 11 July 2023 |
| | | | | US | 2023-0258725 | A1 | 17 August 2023 |
| | | | | WO | 2022-035149 | A1 | 17 February 2022 |
| KR | 10-2441800 | B1 | 13 September 2022 | KR | 10-2019-0041360 | A | 22 April 2019 |
| | | | | US | 11029363 | B2 | 08 June 2021 |
| | | | | US | 2019-0113578 | A1 | 18 April 2019 |
| CN | 113442787 | A | 28 September 2021 | CN | 113442787 | B | 23 June 2023 |
| KR | 10-2022-0126920 | A | 19 September 2022 | KR | 10-2560589 | B1 | 27 July 2023 |

Form PCT/ISA/210 (patent family annex) (July 2022)

**REFERENCES CITED IN THE DESCRIPTION**

**Patent documents cited in the description**

- KR 1020220151069